(19) Europäisches Patentamt
European Patent Office
Office européen des brevets

(11) **EP 4 513 267 A1**

(12) **EUROPEAN PATENT APPLICATION**

(43) Date of publication:
**26.02.2025 Bulletin 2025/09**

(21) Application number: **23193543.8**

(22) Date of filing: **25.08.2023**

(51) International Patent Classification (IPC):
**G03F 7/00** *(2006.01)*

(52) Cooperative Patent Classification (CPC):
**G03F 7/70141; G03F 7/7015; G03F 7/70558;
G03F 7/70566; G03F 7/709**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **ASML Netherlands B.V.
5500 AH Veldhoven (NL)**

(72) Inventor: **Bogaart, Erik, Willem
5500 AH Veldhoven (NL)**

(74) Representative: **ASML Netherlands B.V.
Corporate Intellectual Property
P.O. Box 324
5500 AH Veldhoven (NL)**

(54) **RADIATION INTENSITY CONTROLLING DEVICE FOR EXPOSURES WITH NON-CONSTANT VELOCITY**

(57) Disclosed is an illumination arrangement for an exposure apparatus comprising at least one moveable stage, the illumination arrangement comprising: a polarization configuring element (401) disposed in a propagation path of a polarized radiation beam (405); wherein the polarization configuring element is operable to provide an adjustable intensity of the polarized radiation beam based on a velocity of the at least one moveable stage by comprising a configurable relative angle of a transmission axis (406) of the polarization configuring element with respect to a polarization angle of said polarized radiation beam.

Fig. 4

EP 4 513 267 A1

**Description**

FIELD

The present invention relates to a device for controlling a radiation intensity. Especially it relates to a radiation intensity controlling device and a controlling method thereof, the device may be arranged in an illumination system. The illumination system, comprising the device, may form part of an exposure apparatus to control the exposure dose at a substrate, wherein the substrate is exposed at a non-constant scan velocity.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask or reticle) supported by a mask support onto a layer of radiation-sensitive material (resist) provided on a substrate (e.g., a wafer). A substrate support (e.g., a wafer table or wafer holder) constructed to hold a substrate (e.g., a resist coated wafer) can be moved accurately, e.g., so as to position different target portions in the path of a radiation beam at a focused and aligned position, herewith to project the pattern on the substrate.

As semiconductor manufacturing processes continue to advance, the dimensions of circuit elements have continually been reduced while the substrate throughput is increased. This provides more demanding constrains to lithographic systems. With increasing substrate throughput, the exposure time per target area reduces. As the total dose at the target area needs to remain constant (for proper exposure of the resist), the radiation flux needs to be adapted. Control of the dose is typically arranged by controlling the number of radiation pulses, the pulse repetition rate, and or the radiation pulse intensity directly at the radiation system (e.g., laser system).

Typically, the exposure radiation is provided via a slit that scans over the substrate surface. The dose at the substrate is governed by the actual velocity of the substrate support that supports the substrate and the exposure area at the substrate, so-called slit. The slit is defined by a shape of the opening formed by shielding means, e.g., a masking device comprising masking blades, arranged near the reticle (US2004012913). Especially, the positions of the masking blades in the scan direction control the illumination area during an exposure cycle or exposure period.

In order to achieve a higher substrate throughput of lithographic systems, without the need of excessive high accelerations and velocities of the mask support and substrate support, substrate exposures are performed at non-constant velocity, as is disclosed, for example, in US678839B2. This means that not only the target area is exposed when the substrate support moves with constant velocity, the target area is also exposed during the acceleration and the deceleration of the substrate support

(before and after the exposure period at constant velocity of the substrate support, respectively). To provide a sufficient dose at the target area, the time interval between successive light pulses (from an excimer laser, for example) is inversely proportional to the velocity of the substrate support. This means that the laser pulse rate is adapted to the substrate support velocity, even during acceleration and deceleration of the substrate support. Controlling the exposure dose by varying the laser output (or the output of the radiation system) in response to the velocity of the substrate support may result in instabilities or undesired fluctuations at the laser (or radiation system). As a result, the exposure dose at the substrate may not be at the required level for at least a portion of the target area, which may result in non-yielding dies.

Alternatively, the intensity of the radiation may be changed by means of a transversal moving plate inserted into the radiation beam path, wherein the moving plate is provided with a intensity filter having a gradient transmittance distribution according to a change of velocity of the stages (e.g., US2011123934A1). As such, the moving plate makes a rapidly scanning movement in a plane perpendicular to the radiation beam path. Disadvantages of a rapidly scanning gradient transmissive plate are scanning induced vibrations and the intensity change across the radiation beam, i.e., across the slit area, is not equal. In addition, the gradient profile and the scanning speed need to be coupled.

Modifying the intensity of the radiation beam by means of tilting transmissive plates that are inserted into the beam path, wherein the transmission of the plates is defined by the incident angle of the radiation with the plates (e.g., US 20220357659 A1), may be considered as another alternative configuration. By such a configuration, the position of the radiation beam after the transmissive tilting plates is governed by the actual tilting angle of the plates. That is, the plates cause a transversal shift of the radiation beam that needs to be compensated or corrected for. In addition, to keep up with the relatively high substrate throughput, the plates need to be tilted rapidly. These rapidly tilting plates may introduce disturbances to the system directly by vibrations caused by the mechanical movement, and by air flows caused by the tilt movements. Furthermore, due to the rapid tilting movements of the transmissive plates, the plates are subject to mechanical forces that may introduce deformations of the plates.

# EP 4 513 267 A1

SUMMARY

The invention in a first aspect provides an illumination arrangement for an exposure apparatus comprising at least one moveable stage, the illumination arrangement comprising: a polarization configuring element disposed in a propagation path of a polarized radiation beam; wherein the polarization configuring element is operable to provide an adjustable intensity (e.g., is operable to control an intensity) of the polarized radiation beam based on a velocity of the at least one moveable stage by comprising a configurable relative angle of a transmission axis of the polarization configuring element with respect to a polarization angle of said polarized radiation beam. By means of the illumination arrangement, the radiation intensity (of the exposure radiation beam) during exposures, especially during exposures at non-constant velocities, is controlled. In other words, the dose received at an exposed substrate is controlled even at changing or non-constant velocities of a mask stage and or a substrate stage.

The invention in a second aspect provides an exposure apparatus comprising an illumination arrangement according to the first aspect.

The invention in a third aspect provides a method of adjusting (e.g., controlling) an intensity of a radiation beam for an exposure apparatus comprising at least one moveable stage comprising: disposing a polarization configuring element in a propagation path of the radiation beam; and adjusting (controlling) an intensity of the radiation beam by configuring a relative angle of a transmission axis of the polarization configuring element with respect to a polarization angle of said radiation beam based on a velocity of the at least one moveable stage.

The above and other aspects of the invention will be understood from a consideration of the examples described below.

BRIEF DESCRIPTION OF THE DRAWINGS

Embodiments of the invention will now be described, by way of example only, with reference to the accompanying schematic drawings, in which:

Figure 1 depicts a schematic overview of a lithographic apparatus;
Figure 2 depicts an intensity control element in accordance with some embodiments;
Figure 3 depicts an intensity control element in accordance with some embodiments;
Figure 4 depicts an intensity control element in accordance with some embodiments; and
Figure 5 depicts a plot of the normalized intensity of a radiation beam as a function of relative angle downstream of an intensity controlling element in accordance with some embodiments.

DETAILED DESCRIPTION

In the present document, the terms "radiation" and "beam" are used to encompass all types of electromagnetic radiation, including ultraviolet radiation (e.g., with a wavelength of 365, 248, 193, 157 or 126 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

To clarify the invention, a Cartesian coordinate system is used. The Cartesian coordinate system has three axes, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around the z-axis is referred to as an Rz-rotation. The Cartesian coordinate system is not limiting the invention and is used for clarification only.

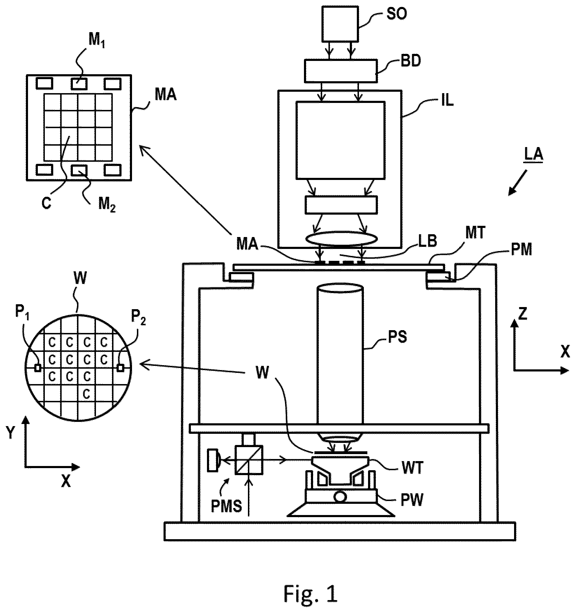

Figure 1 schematically depicts a lithographic apparatus LA, for example, an exposure apparatus suitable for exposing substrates with radiation. The lithographic apparatus LA includes an illumination system (also referred to as illuminator) IL configured to condition a radiation or light beam LB (e.g., UV radiation, DUV radiation or EUV radiation), a mask support (also known as a patterning device support, a patterning device stage, a mask stage, or a mask table) MT constructed to support a patterning device (e.g., a mask) MA and connected to a first positioner configured to accurately position the patterning device MA in accordance with certain parameters, a substrate support (also known as a substrate stage or a wafer table) WT constructed to support and to hold a substrate (e.g., a resist coated wafer) W. A second positioner configured to accurately position the substrate support WT in accordance with certain parameters may be arranged. Both the patterning device support and the substrate support are movable stages. A projection lens system (e.g., a refractive projection lens system) PL configured to project a pattern imparted to the radiation beam LB by patterning device MA (providing a patterned projection beam) onto a target portion (e.g., comprising one or more dies) of the substrate W.

In operation, the illumination system IL receives a radiation beam from a radiation source SO, e.g., via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam LB to have a desired spatial and angular intensity distribution in its cross section at a plane of the patterning device MA.

The term "projection lens system" PL used herein should be broadly interpreted as encompassing various types of projection systems, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PL.

The lithographic apparatus LA may be of a type wherein at least a portion of the substrate may be covered by a liquid having a relatively high refractive index, e.g., water, so as to fill a space between the projection system PL and the substrate W - which is also referred to as immersion lithography. More information on immersion techniques is given in US6952253, which is incorporated herein by reference.

The lithographic apparatus LA, e.g., the exposure apparatus, may have a single substrate support WT arranged to support a substrate W during exposure thereof. The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PL or a property of the radiation beam LB. The measurement stage may hold multiple sensors. The cleaning device may be arranged to clean part of the lithographic apparatus, for example a part of the projection system PL or a part of a system that provides the immersion liquid. The measurement stage may move beneath the projection system PL when the substrate support WT is away from the projection system PL.

In operation, the radiation beam LB is incident on the patterning device (or mask) MA which is held on the mask support MT, and is patterned by the pattern (design layout) present on patterning device MA. Having traversed the mask MA, the radiation beam LB passes through the projection system PL, which focuses the beam onto a target portion of the substrate W. With the aid of the second positioner and a position measurement system, the substrate support WT can be moved accurately, e.g., so as to position different target portions in the path of the radiation beam LB at a focused and aligned position. Similarly, the first positioner and possibly another position sensor (which is not explicitly depicted in Figure 1) may be used to accurately position the patterning device MA with respect to the path of the radiation beam LB. Patterning device MA and substrate W may be aligned using mask alignment marks and substrate alignment marks. Although the substrate alignment marks occupy dedicated target portions, they may be located in spaces between target portions. Substrate alignment marks are known as scribe-lane alignment marks when these are located between the target portions.

A masking device MD is provided for selectively shielding parts of the patterning device MA from the radiation beam LB. In other embodiments, not illustrated by Fig. 1, the masking device MD may be provided to selectively shield parts of the patterned projection beam. As is illustrated in Fig. 1, relay optics (or relay lens) RL is provided for projecting the radiation that passes through the masking device to the patterning device MA.

Accordingly, it is desirable to provide a way of controlling exposure dose that does not cause instabilities in the source SO, does not cause vibrations or mechanical disturbances to the system or apparatus, or does not provide an imbalanced intensity change in the radiation beam LB. In accordance with some embodiments of the present disclosure, to alleviate these issues it is possible to change radiation intensity (i.e., dose) at the patterning device MA and/or substrate W (i.e., at wafer level) as a function of a velocity, or a stage velocity, of at least one moveable stage (e.g., a reticle stage MT and/or a wafer stage WT of a lithographic device).

In some embodiments, an illumination arrangement may be arranged in a beam path of a lithographic apparatus that may comprise a polarization configuring element. Preferably, the illumination arrangement comprising the polarization configuring element may be located in the beam path between a radiation source SO and an illuminator IL (referring to Figure 1). Alternatively, the illumination arrangement comprising the polarization configuring element may be located downstream, e.g., within the illuminator IL. Advantageously, a polarization of the beam may be altered by the polarization configuring element.

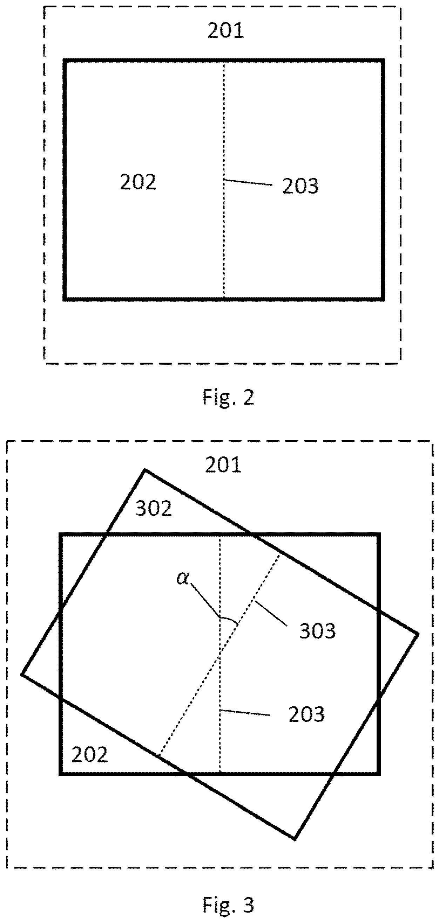

Figure 2 illustrates an embodiment of a polarization configuring element 201 comprising a polarization element 202 (also referred to as a polarization plate or polarizer) which may comprise a transmission axis 203. When transmitted light (i.e., from a radiation source SO) interacts with the polarization element 202, the transmitted light may be linearly polarized in the direction of the transmission axis 203.

In some cases, a radiation source (for example, the radiation source SO as illustrated in Figure 1) may be configured to provide a polarized radiation beam, for example a laser-based radiation beam source. The polarized radiation beam may comprise a polarization angle in a plane perpendicular to a radiation beam propagation direction. The polarization element 202 may be rotatable within a radial plane perpendicular to a radiation beam propagation direction. The polarization element 202, comprising the transmission axis 203, may be rotated with respect to the polarization angle of the polarized radiation beam. That is, the polarization element 202 may be rotatable around an rotation axis directed along the direction of propagation of the radiation. The rotation axis coincides with an axial direction of the radiation beam path. In this way, the alignment of the transmission axis 203 and the polarization angle of the polarized radiation beam may change with respect to one another by relative angle $\alpha$. As relative angle $\alpha$ between the transmission axis 203 and the polarization angle of the polarized radiation beam increases, the intensity of the light transmitted by the polarizing element 202 may decrease. Thus, a single polarizing element (i.e., polarization element 202) may be sufficient to control an intensity of transmitted light when the radiation source (for example, the radiation source SO as illustrated in Figure 1) provides a polarized radiation beam. In this way, an adjusted intensity radiation beam may be provided. Hence, the intensity of the transmitted radiation can be controlled.

Figure 3 illustrates an embodiment of a polarization configuring element 201 (arranged in an illumination arrangement) comprising a first polarization element 202 and a second polarization element 302, each having a respective transmission axis: first transmission axis 203 and second transmission axis 303. The first and second polarization elements 202, 302 and thus the first transmission axis 203 and the second transmission axis 303 may lie within a radial plane perpendicular to the radiation beam propagation direction. The first and second polarization elements 202, 302 may be rotatable with respect to each other and may have a common axis of rotation along an axial direction of a radiation beam path. One, or both, of the first and second polarization elements 202, 302 may be rotated with respect to having aligned transmission axes. In this way, the alignment (or orientation) of the first transmission axis 203 and the second transmission axis 303 may change with respect to one another by relative angle $\alpha$. As relative angle $\alpha$ between the first transmission axis 203 and the second transmission axis 303 increases, the intensity of the light transmitted by the pair of polarization elements 202, 302 may decrease. In this way, an adjusted intensity radiation beam (after being transmitted by the polarization configuring element 201 and the illumination arrangement) may be provided. Such an embodiment, comprising two polarization elements 202, 302, may be used when the input radiation is unpolarized for example.

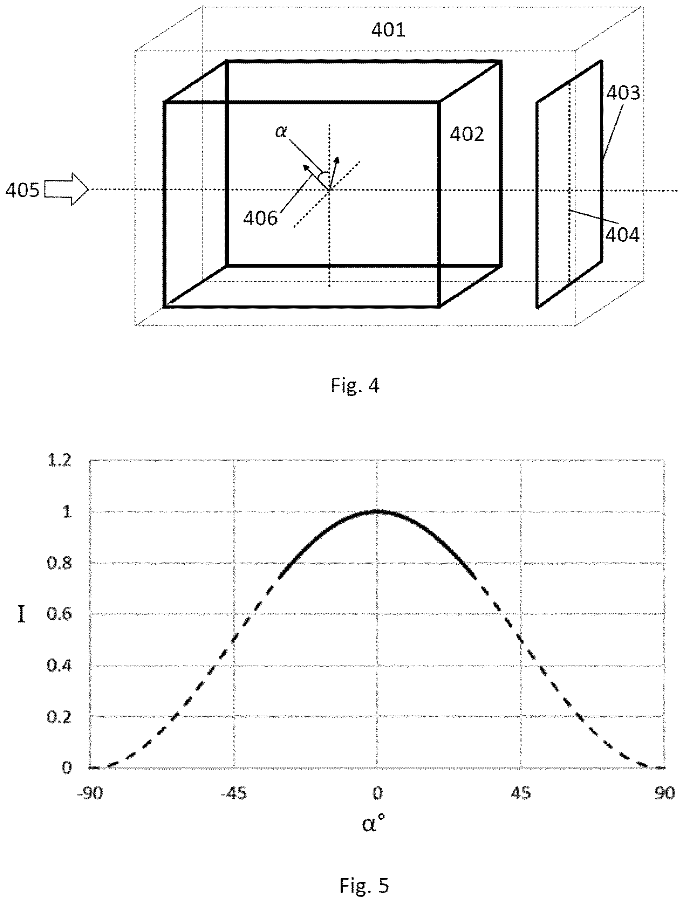

The transmitted radiation intensity as a function of the relative angle $\alpha$ between the first transmission axis (or polarization angle of a polarized radiation beam) and the second transmission axis may be described by Malus's law. Figure 5 shows a plot of the normalized intensity (I) of a radiation beam as a function of relative angle ($\alpha$) downstream of the radiation intensity controlling element (illumination arrangement).

In some embodiments, the polarization configuring element 201 (e.g., one or more rotatable polarization elements 202, 302) may be configured to adjust the radiation intensity of a radiation beam during exposures under a non-constant stage velocity (i.e., a non-constant velocity of a mask support and or a substrate support). That is, the polarization configuring element 201 may be arranged to adjust the intensity of the radiation beam based on, in response to, or as a function of a stage velocity (i.e., the velocity of the mask support and or the substrate support). Thus, in the above embodiments, one or more polarization elements 202, 302 may be rotated (or positioned) to adjust (or to control) the intensity of a transmitted radiation beam as a function of stage velocity. Advantageously, this provides less mechanical disturbance (with respect to, for example, rapidly scanning or tilting plates in accordance with state-of-the-art devices) and the intensity change may be equal across the radiation beam.

In an example, to ensure that an exposure area within each field, (e.g., Fig. 1 target portion C) of a substrate (e.g., Fig. 1 substrate W) receives a correct radiation dose, the rotation of one or more polarization elements 202, 302 may be synchronized with a stage velocity (for example, synchronized with a velocity of substrate support WT), for example to provide a constant time integrated beam intensity or constant dose at mask or substrate level.

Thus, a radiation intensity profile (as a function of time) $I_{exposure}(t)$ (Eq. 2) may be synchronized with a velocity profile of a stage (as a function of time) $V_{stage}(t)$ (Eq. 1) during exposures:

$$V_{stage}(t) = V_0 f(t) \qquad\qquad (1)$$

$$I_{exposure}(t) = I_0 f(t) \sim cos^2 \alpha(t) \qquad (2)$$

where $V_0$ represents the maximum velocity / speed of the stage (i.e., the mask support or substrate support), $I_0$ denotes the maximum intensity, f(t) represents a time-dependent profile of the one or more stages, and $\alpha(t)$ represents the time-dependency of the relative angle. Hence, the radiation intensity used for exposing a mask / substrate is governed by the over time-varying (transient) stage velocity.

The velocity profile is not limited to a cosines-shape profile. Any non-constant velocity profile may be used. Therefore, the rotation of one or more polarization elements 202, 302 (and hence an adjustment of relative angle $\alpha$) may be

synchronized with a stage velocity.

With reference to Figure 3, the illumination arrangement can be considered to be a radiation intensity controlling system for use in a radiation beam path. As such, the radiation controlling system comprises a first polarizing element 202 having a first transmission axis 203 and a second polarizing element 302 having a second transmission axis 303, wherein the polarizing elements 202, 302 are configured to rotate with respect to each other along a common axis of rotation along the direction of the radiation beam path. The intensity of the radiation after the first and second elements is controlled by controlling the angle in synchronization with a velocity of a substrate stage and/or patterning device stage. A control unit may be provided and configured to control an angle $\alpha$ between the first and second transmission axis.

Figure 4 illustrates an embodiment of a polarization configuring element 401 comprising an electro-optical element 402, which may be arranged in an illumination arrangement. An electro-optical element 402 may comprise an adjustable transmission axis 406 (e.g., having a fast axis and a slow axis), and may be capable of changing a polarization direction of a polarized radiation beam 405. That is, the orientation of the transmission axis 406 may be adjusted or changed. The transmission axis 406 of the electro-optical element 402 may be controlled by a control signal, for example a control voltage. The polarization configuring element 401 may further comprise an output polarization element 403 located downstream of the electro-optical element 402. In this way, the intensity of a radiation beam 405 transmitted through the electro-optical element 402 and the output polarization element 403 may depend on the direction of polarization of the radiation beam 405 after the electro-optical element 402 and the direction of a transmission axis 404 of the output polarization element 403. Thus, the orientation (or direction) of the transmission axis 406 of the electro-optical element 402 may be adjustable to adjust (or to control) a relative angle $\alpha$ between the transmission axis 406 of the electro-optical element 402 and the transmission axis 404 of the downstream output polarization element 403.

Advantageously, the illumination arrangement comprising the polarization configuring element 401 comprising an electro-optical element 402 and an output polarization element 403 requires no moving parts to adjust the intensity of a transmitted radiation beam 405, which may minimize vibrations and other mechanical disturbances in an exposure tool or the like. As above, control of the polarization configuring element 401 (e.g., the electro-optical element 402) and thus the intensity of the transmitted radiation beam 405 may be advantageously based on, in response to, or a function of a stage velocity, i.e., a velocity of the mask support and or a substrate support.

In an example, to ensure that an exposure area within each field (e.g., Fig. 1 target portion C) of a substrate (e.g., Fig. 1 substrate W) receives a correct dose, an adjustment of adjustable transmission axis 406 may be synchronized with a stage velocity (e.g., Fig. 1 a velocity of substrate support WT), for example to provide a constant time integrated beam intensity or constant dose at mask or substrate level.

As described in relation to Figure 2 and Figure 3 embodiments, the velocity profile is not limited to a cosines-shape profile. Any non-constant velocity profile may be used. Therefore, an adjustment of adjustable transmission axis 406 (and hence an adjustment of relative angle $\alpha$) may be synchronized with a stage velocity, for example, synchronized with a velocity of substrate support WT.

The arrangement of Figure 4 assumes a polarized input radiation beam 405. If the radiation source is unpolarized, then the polarization configuring element 401 may comprise an input polarizing element (not shown) between the radiation source and electro-optical element 402 (e.g., as with the embodiment illustrated in Figure 3).

In some embodiments there may be provided a processing arrangement, for example a control system of an exposure apparatus, operable to adjust an intensity of a polarized radiation beam based on a velocity of at least one movable stage (i.e., mask support, substrate support). The processing arrangement may be operable to receive or calculate a velocity of the at least one movable stage and provide a control signal for a polarization configuring element 201, 401 based on said received or calculated velocity, so as to adjust an intensity of the radiation beam in accordance with said received or calculated velocity.

In some embodiments the processing arrangement may provide a control signal to a polarization configuring element 201 comprising one or more rotatable polarizing elements 202, 302. The control signal may cause at least one of the one or more polarizing elements 202, 302 to rotate around a propagation path of the polarized radiation beam (i.e., around a rotation axis coinciding with the radiation beam path) based on said received or calculated velocity, so as to adjust (and to control) an intensity of the polarized radiation beam in accordance with said received or calculated velocity.

In some embodiments the processing arrangement may provide a control signal to a polarization configuring element 401 comprising an electro-optical element 402 having a configurable transmission axis 406. The control signal may configure the orientation of the transmission axis 406 of the electro-optical element 402 based on said received or calculated velocity, so as to adjust an intensity of the polarized radiation beam in accordance with said received or calculated velocity. The control signal may be a voltage provided to electrical contacts arranged at the electro-optical element 402.

The control system may be configured to be in communication with the first positioner and or the second positioner. This may be have the advantage to synchronize the illumination arrangement with the movable stages.

In some embodiments there may be provided an exposure apparatus comprising: a substrate stage (i.e., substrate support or wafer table) WT operable to support a substrate W; a patterning device stage (i.e., patterning device support or mask support) MT operable to support a patterning device MA; an illumination arrangement comprising a polarization configuring element 201, 401 operable to provide an adjustable intensity of a radiation beam based on a velocity of the substrate stage and/or the patterning device stage to provide an adjusted intensity radiation beam; and an illuminator module for illuminating at least a portion of said patterning device with said adjusted intensity radiation beam. The illumination arrangement may be located before the illuminator module, or the illumination arrangement may be located within the illuminator module.

The above-mentioned configurations are not limiting examples. For example, a polarization configuring element 201, 401 may comprise one or more polarizing elements 202, 302 or electro-optical elements 402 or output polarizing elements 403 as required by a system or particular implementation. In some or all cases, a radiation source may be configured to provide a polarized radiation beam (e.g., a laser-based radiation source), or alternatively a polarized radiation beam may be provided by one or more input polarizing elements (e.g., polarization element 202). Hence, the input polarizing element is operable to polarize an input radiation beam to obtain the polarized radiation beam. Any suitable type of polarizing element may be used to achieve the advantages described herein. The input polarizing element may be rotatable around the propagation path of the polarized beam. That is, the input polarizing element may be arrange to be rotatable around an axis of rotation along the propagation direction of the input radiation beam and polarized radiation beam.

The embodiments disclosed above are most relevant for exposures with stages having a non-constant velocity. To ensure that each area within each field (target portion C) at the substrate W receives a proper dose (or the time integrated intensity is constant), the angle $\alpha$ or the orientation of the polarizing element is synchronized with the stage velocity.

The illumination arrangements as disclosed above, separate or arranged in an apparatus, may be considered to be a radiation intensity adjustment or controlling system.

In some cases, radiation may be absorbed by one or more of the polarizing elements 202, 302, electro-optical element 402, or output polarizing element 403. Advantageously, a thermal control means may be implemented in any of the described systems to mitigate the effects of absorbed radiation.

While specific embodiments of the invention have been described above, it will be appreciated that the invention may be practiced otherwise than as described.

The terms "radiation" and "beam" used herein encompass all types of electromagnetic radiation, including ultraviolet (UV) radiation (e.g., having a wavelength of or about 365, 355, 248, 193, 157 or 126 nm) .

The term "lens", where the context allows, may refer to any one or combination of various types of optical components, including refractive and reflective optical components. Reflective components are likely to be used in an apparatus operating in the UV ranges.

It will be appreciated by the skilled person that features of different aspects of the invention, as disclosed above, may be combined together.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquidcrystal displays (LCDs), thin-film magnetic heads, etc.

Although specific reference may be made in this text to embodiments of the invention in the context of a lithographic apparatus, embodiments of the invention may be used in other exposure apparatuses. Embodiments of the invention may form part of a mask inspection apparatus, a metrology apparatus, or any apparatus that measures or processes an object such as a wafer (or other substrate) or mask (or other patterning device) via exposure to radiation. These apparatus may be generally referred to as exposure apparatuses or lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g., carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Aspects of the invention are set out in the clauses below.

1. An illumination arrangement for an exposure apparatus comprising at least one moveable stage, the illumination arrangement comprising: a polarization configuring element disposed in a propagation path of a polarized radiation beam; wherein the polarization configuring element is operable to provide an adjustable intensity of the polarized radiation beam based on a velocity of the at least one moveable stage by comprising a configurable relative angle of a transmission axis of the polarization configuring element with respect to a polarization angle of said polarized radiation beam.

2. The illumination arrangement according to clause 1, wherein said polarization configuring element comprises one or more polarization elements, wherein at least one of said one or more polarization elements is rotatable within a radial plane perpendicular to the propagation path of the polarized beam to configure said configurable relative angle.

3. The illumination arrangement according to clause 1, wherein said polarization configuring element comprises an electro-optical element having an adjustable transmission axis; and said illumination arrangement further comprises an output polarization element located downstream of said electro-optical element.

4. The illumination arrangement according to clause 3, wherein the transmission axis of the electro-optical element is adjustable based on a control signal.

5. The illumination arrangement according to any preceding clause, further comprising an input polarizing element operable to polarize an input radiation beam to obtain said polarized radiation beam.

6. The illumination arrangement according to clause 5, wherein said input polarizing element is configured to be rotatable around the propagation path of the polarized radiation beam.

7. The illumination arrangement according to clause 6, being further operable to adjust said intensity of the polarized radiation beam by rotating said input polarizing element to configure said configurable relative angle.

8. The illumination arrangement according to clause 5, 6 or 7, further comprising a radiation source configured to provide the input radiation beam.

9. The illumination arrangement according to any of clauses 1 to 4 further comprising a radiation source configured to provide the polarized radiation beam.

10. The illumination arrangement according to any previous clause further comprising a processing arrangement being operable to: receive or calculate a velocity of the at least one moveable stage; and provide a control signal for said polarization configuring element based on said received or calculated velocity, so as to adjust said intensity of the polarized radiation beam in accordance with said received or calculated velocity.

11. An exposure apparatus comprising: a substrate stage operable to support a substrate; a patterning device stage operable to support a patterning device; the illumination arrangement of any preceding clause, being operable to provide an adjustable intensity of a radiation beam based on a velocity of the substrate stage and/or the patterning device stage to provide an adjusted intensity radiation beam; and. an illuminator module for illuminating at least a portion of said patterning device with said adjusted intensity radiation beam.

12. The exposure apparatus according to clause 11, wherein said illumination arrangement is arranged before said illuminator module.

13. The exposure apparatus according to clause 11, wherein said illumination arrangement is arranged within said illuminator module.

14. A method of adjusting (or controlling) an intensity of a polarized radiation beam for an exposure apparatus comprising at least one moveable stage comprising: disposing a polarization configuring element in a propagation path of the polarized radiation beam; and adjusting (or controlling) an intensity of the radiation beam by configuring a relative angle of a transmission axis of the polarization configuring element with respect to a polarization angle of said polarized radiation beam based on a velocity of the at least one moveable stage.

15. The method according to clause 14, wherein said polarization configuring element comprises at least one polarization element and wherein the adjusting step comprises rotating the at least one polarization element around the propagation path of the polarized beam.

16. The method according to clause 14 wherein said polarization configuring element comprises an electro-optical element having an adjustable transmission axis; and an output polarization element arranged downstream of said electro-optical element.

17. The method according to clause 16, wherein the adjusting step comprises adjusting an orientation of the transmission axis of the electro- optical element based on a control signal.

18. The method according to any of clauses 14 to 17 further comprising providing the polarized radiation beam by using an input polarizing element.

19. The method according to clause 18 further comprising rotating the input polarizing element around the propagation path of the polarized radiation beam to configure the relative angle.

20. The method according to clauses 18 or 19 further comprising providing a radiation source configured to provide an input radiation beam.

21. The method according to any of clauses 14 to 17 further comprising providing a radiation source for providing the polarized radiation beam.

22. The method according to any of clauses 14 to 21 further comprising: receiving or calculating a velocity of the at least one moveable stage; providing a control signal for said polarization configuring element based on said received or calculated velocity; and adjusting the intensity of the polarized radiation beam in accordance with said received or calculated velocity.

23. A method of operating an exposure apparatus comprising the illumination arrangement of any of clauses 1 to 10, the method comprising: supporting a substrate on a substrate stage; supporting a patterning device on a patterning device stage; providing an adjusted intensity radiation beam based on a velocity of the substrate stage and/or the patterning device stage; and illuminating, by an illuminator module, at least a portion of said patterning device with said adjusted intensity radiation beam.

24. The method according to clause 23 further comprising disposing the illumination arrangement upstream of said illuminator module.

25. The method according to clause 23 further comprising disposing the illumination arrangement within said illuminator module.

26. A radiation intensity controlling system for use in a radiation beam path, comprising: a first polarizing element having a first transmission axis and a second polarizing element having a second transmission axis, wherein the polarizing elements are configured to rotate with respect to each other along a common axis of rotation along the direction of the radiation beam path; and wherein the intensity of the radiation after the first and second elements is controlled by controlling the angle in synchronization with a velocity of a substrate stage and/or patterning device stage.

27. The radiation intensity controlling system according to clause 26, further comprising a control unit configured to control an angle between the first and second transmission axis.

The breadth and scope of the present invention should not be limited by any of the above-described exemplary embodiments, but should be defined only in accordance with the following claims and their equivalents.

## Claims

1. An illumination arrangement for an exposure apparatus comprising at least one moveable stage, the illumination arrangement comprising:

   a polarization configuring element disposed in a propagation path of a polarized radiation beam;
   wherein the polarization configuring element is operable to provide an adjustable intensity of the polarized radiation beam based on a velocity of the at least one moveable stage by comprising a configurable relative angle of a transmission axis of the polarization configuring element with respect to a polarization angle of said polarized radiation beam.

2. The illumination arrangement as claimed in claim 1, wherein said polarization configuring element comprises one or more polarization elements, wherein at least one of said one or more polarization elements is rotatable within a radial plane perpendicular to the propagation path of the polarized beam to configure said configurable relative angle.

3. The illumination arrangement as claimed in claim 1, wherein said polarization configuring element comprises an electro-optical element having an adjustable transmission axis; and
   said illumination arrangement further comprises an output polarization element located downstream of said electro-optical element.

4. The illumination arrangement as claimed in claim 3, wherein the transmission axis of the electro-optical element is adjustable based on a control signal.

5. The illumination arrangement as claimed in any preceding claim, further comprising an input polarizing element operable to polarize an input radiation beam to obtain said polarized radiation beam.

6. The illumination arrangement as claimed in any previous claim further comprising a processing arrangement being operable to:

   receive or calculate a velocity of the at least one moveable stage; and
   provide a control signal for said polarization configuring element based on said received or calculated velocity, so as to adjust said intensity of the polarized radiation beam in accordance with said received or calculated velocity.

7. An exposure apparatus comprising:

   a substrate stage operable to support a substrate;
   a patterning device stage operable to support a patterning device;
   the illumination arrangement of any preceding claim, being operable to provide an adjustable intensity of a radiation beam based on a velocity of the substrate stage and/or the patterning device stage to provide an adjusted intensity radiation beam; and.
   an illuminator module for illuminating at least a portion of said patterning device with said adjusted intensity radiation beam.

8. A method of adjusting an intensity of a polarized radiation beam for an exposure apparatus comprising at least one moveable stage comprising:

   disposing a polarization configuring element in a propagation path of the polarized radiation beam; and
   adjusting an intensity of the radiation beam by configuring a relative angle of a transmission axis of the polarization configuring element with respect to a polarization angle of said polarized radiation beam based on a velocity of the at least one moveable stage.

9. The method as claimed in claim 8, wherein said polarization configuring element comprises at least one polarization element and wherein the adjusting step comprises rotating the at least one polarization element around the propagation path of the polarized beam.

10. The method as claimed in claim 8 wherein said polarization configuring element comprises an electro-optical element having an adjustable transmission axis; and
    an output polarization element arranged downstream of said electro-optical element.

11. The method as claimed in claim 10, wherein the adjusting step comprises adjusting an orientation of the transmission axis of the electro-optical element based on a control signal.

12. The method as claimed in any of claims 8 to 11 further comprising providing the polarized radiation beam by using an input polarizing element.

13. The method as claimed in claim 12 further comprising rotating the input polarising element around the propagation path of the polarized radiation beam to configure the relative angle.

14. The method as claimed in claims 12 or 13 further comprising providing a radiation source configured to provide an input radiation beam.

15. The method as claimed in any of claims 8 to 14 further comprising:

   receiving or calculating a velocity of the at least one moveable stage;
   providing a control signal for said polarization configuring element based on said received or calculated velocity; and
   adjusting the intensity of the polarized radiation beam in accordance with said received or calculated velocity.

Fig. 1

Fig. 2

Fig. 3

Fig. 4

Fig. 5

Europäisches
Patentamt

European
Patent Office

Office européen
des brevets

# EUROPEAN SEARCH REPORT

Application Number

**EP 23 19 3543**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/317058 A1 (YAMAMOTO MASAYA [JP] ET AL) 6 October 2022 (2022-10-06) | 1,5,6,8, 11,12, 14,15 | INV. G03F7/00 |
| Y | * paragraph [0038] * <br> * paragraphs [0083] - [0087]; figures 12,13 * <br> ----- | 2-4,7,9, 10,13 | |
| Y,D | US 2011/123934 A1 (ASAISHI TADAHIRO [JP]) 26 May 2011 (2011-05-26) <br> * paragraph [0015] * <br> * paragraphs [0025] - [0030]; figures 1A,1B * <br> * paragraphs [0035] - [0041]; figure 3 * <br> ----- | 7 | |
| Y,D | US 2022/357659 A1 (KOBAYASHI DAISUKE [JP]) 10 November 2022 (2022-11-10) <br> * paragraph [0034]; figure 1 * <br> ----- | 2,9,13 | |
| Y | WO 2023/119589 A1 (HITACHI HIGH TECH CORP [JP]) 29 June 2023 (2023-06-29) <br> * paragraphs [0056] - [0073]; figure 1 * <br> * paragraphs [0114] - [0119]; figure 13 * <br> ----- | 3,4,10 | TECHNICAL FIELDS SEARCHED (IPC) <br><br> G03F |

The present search report has been drawn up for all claims

| Place of search | Date of completion of the search | Examiner |
|---|---|---|
| Munich | 6 February 2024 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 23 19 3543**

This annex lists the patent family members relating to the patent documents cited in the above-mentioned European search report.
The members are as contained in the European Patent Office EDP file on
The European Patent Office is in no way liable for these particulars which are merely given for the purpose of information.

**06-02-2024**

| Patent document cited in search report | Publication date | Patent family member(s) | Publication date |
|---|---|---|---|
| US 2022317058 A1 | 06-10-2022 | US 2022317058 A1<br>WO 2021014623 A1 | 06-10-2022<br>28-01-2021 |
| US 2011123934 A1 | 26-05-2011 | JP 2011109014 A<br>US 2011123934 A1 | 02-06-2011<br>26-05-2011 |
| US 2022357659 A1 | 10-11-2022 | CN 115309001 A<br>JP 2022172904 A<br>KR 20220152138 A<br>US 2022357659 A1 | 08-11-2022<br>17-11-2022<br>15-11-2022<br>10-11-2022 |
| WO 2023119589 A1 | 29-06-2023 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2004012913 A
- US 678839 B2
- US 2011123934 A1
- US 20220357659 A1
- US 6952253 B